(19) Europäisches Patentamt

European Patent Office

Office européen des brevets

(11) **EP 0 898 445 A2**

(12) **EUROPEAN PATENT APPLICATION**

(43) Date of publication:
**24.02.1999 Bulletin 1999/08**

(51) Int Cl.$^6$: **H05K 13/00**

(21) Application number: **98306666.3**

(22) Date of filing: **20.08.1998**

(84) Designated Contracting States:
**AT BE CH CY DE DK ES FI FR GB GR IE IT LI LU MC NL PT SE**
Designated Extension States:
**AL LT LV MK RO SI**

(30) Priority: **21.08.1997 US 915962**

(71) Applicant: **Rexham Industries Corp.**
**Charlotte, NC 28209 (US)**

(72) Inventor: **Holley, Leonard**
**Walkertown, NC 27051 (US)**

(74) Representative: **Shanks, Andrew et al**
**Cruikshank & Fairweather,**
**19 Royal Exchange Square**
**Glasgow G1 3AE (GB)**

(54) **Transparent static dissipative heat sealable cover tape**

(57)    A transparent, static dissipative cover tape is disclosed. The transparent, static dissipative cover tape comprises a polyester-based substrate having respective first and second surfaces and a transparent, static dissipative layer on the first surface of said substrate, wherein the polyester based substrate comprises respective first and second polyester laminae secured to one another by a pressure sensitive adhesive interposed between the first and second laminae. Preferably the transparent, static dissipative cover tape comprises a transparent, static dissipative, heat sealable layer on a second surface of said substrate opposite the first surface comprising either polyaniline or an organotitanate in a styrene-butadiene copolymer matrix. Generally, the transparent, static dissipative cover tape further comprises a tie layer, a first styrene-butadiene copolymer heat sealable base layer, and optionally a second styrene-butadiene copolymer heat sealable base layer interposed between the polyester-based substrate and the transparent, static dissipative, heat sealable layer. The invention further comprises a static-protective package for electronic components and a method of sealing an electronic component in a static-protective package. The transparent, static dissipative cover tape of the invention has increased clarity and adhesive stability over conventional cover tapes.

Fig.2.

**Description**

Field of the Invention

The present invention relates to the packaging and handling of small electronic components, and in particular relates to the antistatic packaging of such components in carrier tapes and the like.

Background of the Invention

Small electronic components such as integrated circuits (chips), transistors, diodes, condensers, piezoelectric resistors, and the like are often packaged in linear packages known as carrier tapes. These carrier tapes often consist of plastic strips of molded pockets, and are frequently bordered by sprocket holes. By packaging the components in such a manner, the strips can be mechanically fed or advanced along a fully or partially automated assembly line. In such lines, the components are frequently removed from the strip's pockets by automated equipment which then places the components in their next desired position, for example on a circuit board. When originally packaged and shipped in the strips, the pocketed components are also secured in place by a cover tape that overlies the pockets.

The overlying cover tape is generally a heat sealable tape that matches the width of the pocketed strip and adheres to the perimeter of the carrier tape. Preferably, the tape should be transparent so that the identity of the components in the pockets is clearly visible. Furthermore, in many circumstances the tape also should be static dissipative or antistatic in character in order to protect the components from the potentially harmful effects of static electricity. Because static electricity can build up on either or both sides of the cover tape, preferably both sides of the cover tape should have antistatic characteristics. In addition to adversely affecting the packaged components, static electricity can cause handling problems by attracting dust, or even by attracting lighter weight components to the tape in a manner analogous to the way in which a child's plastic balloon can be made to stick to a wall.

As generally used, the terms "antistatic" and "static dissipating" both refer to the same property: conductivity. The term "static dissipating" generally refers to a higher conductivity than does the term "antistatic." For example, antistatic is often used to characterize resistivities of $10^9$ to $10^{14}$ ohms per square, while static dissipative is used to characterize resistivities of $10^5$ to $10^9$ ohms per square. It will be understood that these terms are thus used descriptively herein, rather than in any absolute or unreasonably limiting sense. In the invention set forth in the Detailed Description that follows, the structures are of higher conductivity and thus best described as static dissipative.

Some of the traditional or conventional compounds used to obtain antistatic and static dissipative properties include carbon black and quaternary ammonium salts. Carbon black, however, lacks transparency when used in amounts sufficient to provide the desired static dissipative properties. Quaternary salts are disadvantageously sensitive to moisture so that their conductivity can change based on changes as slight as changes in the ambient relative humidity. Therefore, a static dissipative cover tape for integrated circuit components or the like needs to be more transparent than carbon black and more consistent in its antistatic properties than quaternary ammonium salts.

Furthermore, because automated or robotic equipment is often used to open the packages and remove the cover tape, the tape must exhibit very consistent adhesive characteristics with respect to the carrier tape. Stated differently, the peel force needed to remove the cover tape from the carrier tape (i.e., needed to overcome the strength of the seal between the cover tape and the carrier tape) must be consistent within each package and from package to package. Preferably, the peel force needed to remove the cover tape from the carrier tape is also consistent over time because such packages may be stored for several months before use. In addition, the seal strength must be sufficiently high to maintain the seal between the cover tape and the carrier tape when the package is transported but sufficiently low to prevent vibration of the package upon opening and the possible loss of the electronic components.

Object and Summary of the Invention

Therefore, it is an object of the present invention to provide an improved transparent, static dissipative cover tape for electronic component packages.

The invention meets this object with a transparent, static dissipative cover tape which comprises a polyester-based substrate having respective first and second surfaces and a transparent, static dissipative layer on the first surface of the substrate, wherein the polyester based substrate comprises respective first and second polyester laminae secured to one another by a pressure sensitive adhesive interposed between the first and second laminae. Preferably, the transparent, static dissipative cover tape comprises a transparent, static dissipative, heat sealable layer on a second surface of the substrate opposite the first surface comprising either polyaniline or an organotitanate in a styrene-butadiene copolymer matrix. Generally, the transparent, static dissipative cover tape further comprises a tie layer, a first styrene-butadiene copolymer heat sealable base layer, and optionally a second styrene-butadiene copolymer heat sealable base layer interposed between the polyester-based substrate and the transparent, static dissipative, heat sealable layer.

In another aspect, the invention comprises a static-protective package for electronic components comprising a carrier tape for electronic components having a raised outer perimeter and at least one recessed portion within the perimeter, at least one electronic component positioned in said recessed portion, and a transparent, static dissipative cover tape adhered to the perimeter of the carrier tape.

In yet another aspect, the invention comprises a method of sealing an electronic component in a static-protective package comprising inserting an electronic component into a recessed portion of a carrier tape, applying a transparent, static dissipative, heat sealable cover tape to the carrier tape to enclose the electronic component, and heating and pressurizing a portion of the cover tape for a predetermined dwell time to adhere the cover tape to the carrier tape and to seal the electronic component within the static-protective package.

The transparent, static dissipative cover tape of the invention has increased clarity over conventional cover tapes and is constructed of a lower modulus material which reduces the amount of heat sealable material necessary to adhere the cover tape to the carrier tape. The resulting peel force necessary to separate the cover tape from the carrier tape is therefore consistent from package to package and does not increase greatly over time which makes the static-protective package of the invention more storage stable than conventional cover tapes. In addition, the cover tapes may be removed from the carrier tape at peel angles approaching 180° which allows for minimization in the vibrations of the package when it is peeled open and smooth release of the cover tape from the carrier tape.

The foregoing and other objects, advantages and features of the invention, and the manner in which the same are accomplished, will become more readily apparent upon consideration of the following detailed description of the invention taken in conjunction with the accompanying drawings, which illustrate preferred and exemplary embodiments, and wherein:

Brief Description of the Drawings

Figure 1 is an environmental view in perspective showing a carrier strip of the type with which the cover tape of the present invention is used; and

Figure 2 is a cross-sectional view of a preferred embodiment of the cover tape of the present invention, and taken along lines 2-2 of Figure 1.

Detailed Description of the Preferred Embodiments

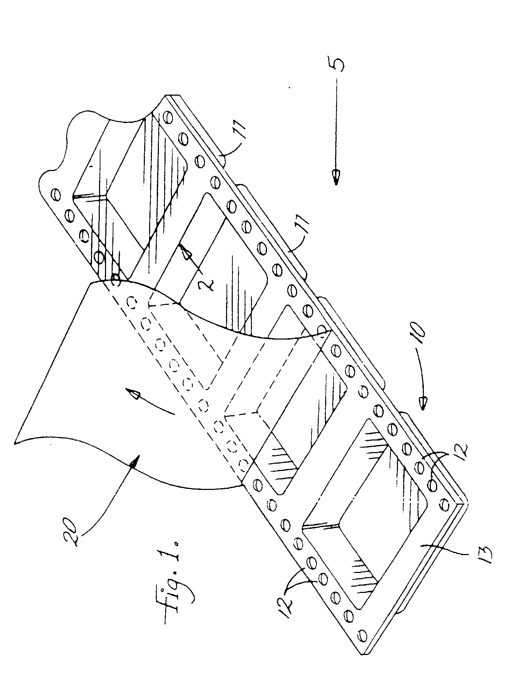

The present invention is a transparent static dissipative cover tape. Figure 1 shows the tape in one of its most useful environments, a cover tape for packaging electronic components such as integrated circuits (chips), transistors, diodes, condensers, piezoelectric resistors, and the like. In Figure 1, a static-protective package 5 for electronic components comprises a pocketed carrier tape 10 and a cover tape 20 adhered to the carrier tape. The cover tape 20 of the present invention in Figure 1 is illustrated in a partially removed orientation. Four recessed portions or pockets 11 are illustrated in which the electronic components are carried. For the sake of clarity of illustration, the pockets 11 are shown as being empty, but their purpose will be understood to one skilled in the art. The recessed portions 11 have physical dimensions (i.e., area and depth) which generally correspond to the electronic components packaged therein and are preferably rectangular in shape. A plurality of sprocket holes 12 typically run longitudinally along the carrier tape 10, and although illustrated as being circular, the holes 12 could similarly be square, rectangular, or some other shape as desired or necessary. Similarly, although Figure 1 shows two parallel rows of sprocket holes 12, it will be understood that other tapes may have several rows or only one row, and yet others have none and are handled by some other mechanism. The carrier tape 10 is generally made of plastic and further contains an outer perimeter or edge 13 which is substantially planar and raised in relation to the recessed portions 11 of the carrier tape. A cover tape 20 is adhered to the perimeter 13 of the carrier tape 10 to seal the electronic components in the recessed portions 11 of the carrier tape to form the package 5. Although Figure 1 illustrates a package 5 containing a carrier tape 10, it would be understood to one skilled in the art that several other types of packages such as flat packs, leadless chip carriers, leaded chip carriers, small-outline integrated circuits, pin-grid arrays, dual in-line packages, and the like could alternatively be used in the invention.

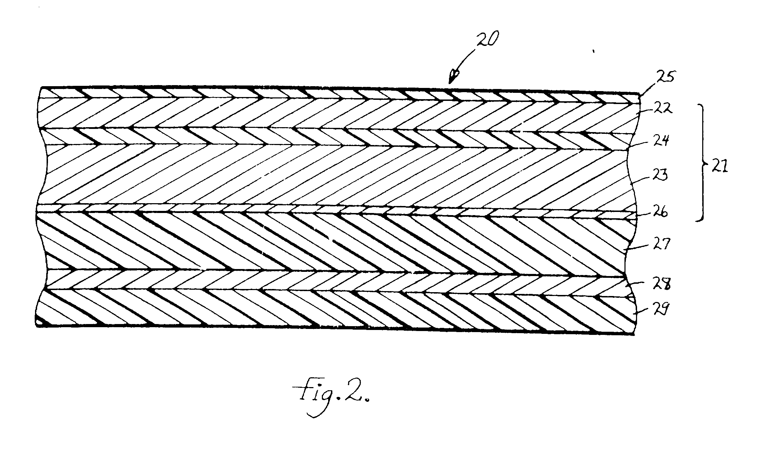

Figure 2 is a cross-sectional view of a preferred embodiment of cover tape 20. The cover tape 20 first comprises a transparent polymer substrate 21. Preferably, the transparent polymer substrate 21 is laminated and comprises respective first and second polyester laminae 22 and 23 secured to one another by a pressure sensitive adhesive 24 interposed between the first and second laminae. The preferred material for the substrate 21 is a transparent, low modulus, flexible material such as a polyester (including other polyesters in addition to polyethylene terephthalate). Nevertheless, other low modulus substrates could be used including nylons, polypropylene, polyurethanes, polyethylene, ethylene vinyl acetate copolymers, polystyrene, polyimides, polyvinyl chlorides, polyester copolymers, mixtures thereof, laminates including one or more layers thereof, and the like. The low modulus substrate **21** provides a soft, pliable cover tape **20** without sacrificing the toughness and tear strength of the cover tape. In addition, the polyester-based substrate **21** possesses less haze than conventional polymer substrates and therefore, increases the transparency of the cover tape **20**.

The laminated substrates, such as the polyester-based substrate **21** are generally formed by separately forming the laminae and then using the adhesive **24** to adhere the laminae together to form the substrate. Nevertheless, the laminated substrate **21** may be formed by coextrusion or other methods known in the art. In addition, although the laminated substrate **21** of Figure 1 illustrates two polymer layers and one adhesive layer, it would be understood by one skilled in the art that the laminated substrate **21** of the invention includes two or more layers and provides the desired low modulus, flexible substrate.

The laminated, polyester-based substrate **21** is generally not more than about 1.2 mils thick and is preferably about 1.05 mils thick or less. As illustrated in Figure 2, the first lamina **22** defines the outer portion of the laminated substrate **21** and is preferably about 0.25 mils thick. The second lamina **23** defines the inner portion of the laminated substrate and is preferably about 0.60 mils thick. The pressure sensitive adhesive **24** is preferably applied at between about 3 and 4 pounds per ream between the first and second laminae **22** and **23**. The resulting pressure sensitive adhesive layer **24** in the laminated substrate **21** is between about 0.15 and 0.20 mils thick. Preferably, the pressure sensitive adhesive **24** is a tacky polymer such as an acrylic copolymer, e.g., GELVA® Multipolymer Solution 2495, sold by Monsanto Co., but other pressure sensitive adhesives may be used which will sufficiently adhere the laminae together to prevent failure at the interface between the laminae when the cover tape **20** is peeled from the carrier tape **10**. The use of a laminated substrate **21** allows less polyester material to be used and therefore decreases the modulus and the thickness of the substrate. The reduced modulus and thickness provides a cover tape **20** with increased clarity, peel consistency, and storage stability than conventional cover tapes as discussed hereinbelow.

In the cross-sectional orientation of Figure 2, the chips are packaged below the substrate **21**, while the exposed face would be above the polyester layer **21**. The first or upper surface of the substrate **21** includes at least one transparent, static dissipative layer **25**. The transparent, static dissipative layer **25** preferably comprises a static dissipative composition such as anionic antistatic compositions, nickel-chromium alloys (e.g., Nichrome), magnesium silicate ("Laponite") clays, and the like. Commercially available Nichrome and Laponite clays are described in U.S. Pat. No. 5,447,784 to Williams et al. which is incorporated herein by reference in its entirety. Preferably, the static dissipative composition is an anionic antistatic composition such as a sulfonated polystyrene (e.g., VERSA TL-125 from National Starch and Chemical Co). The static dissipative composition preferably further comprises a wetting agent such as FC-129 from 3M Co., isopropyl alcohol, and water. The resistivity of the transparent, static dissipative layer **25** is typically between about $10^6$ and $10^8$ ohms/square, depending on the moisture and thickness of the transparent, static dissipative layer.

In preferred embodiments, the second or inner surface of the substrate **21** is coated with a primer or tie layer **26** which forms an appropriate transition between the substrate **21** and the heat sealable layers adjacent to the substrate. Preferably, the tie layer **26** is a copolyester compound such as an isophthalic copolymer. The copolyester tie layer **26** may be provided on the second polyester lamina **23** prior to laminating the first and second laminae **22** and **23** with the pressure sensitive adhesive **24** to form a "treated" polyester lamina **23** or may be applied after the laminated substrate is formed. Suitable "treated" polyester films may be purchased from ICI Films as Melinex® 301 H, Melinex® 850H, or Melinex® 851H. Other polymers which may also be suitable for the tie layer **26** of the invention include polyurethanes, polyesters, nitrile phenolics, and acrylic copolymers. The tie layer **26** prevents the polyester-based substrate **21** from separating from the transparent, heat sealable base layer **27** (described below) when the cover tape **20** is peeled from the carrier tape **10**.

The cover tape **20** of the invention typically further includes at least one transparent, heat sealable base layer **27** on the tie layer **26** of the cover tape. Preferably, the base layer **27** comprises a heat sealable polymer which is nonblocking at ambient temperatures and which becomes tacky only at elevated temperatures, e.g., greater than 150°C. The heat sealable polymer is preferably a styrene-butadiene rubber (SBR) copolymer such as Kraton 1650 sold by Shell Chemical Company. These copolymers are elastomeric compositions and are typically formed by the copolymerization of three parts butadiene to one part styrene as is well known to one skilled in the art. Alternatively, the polymeric matrix may comprise chlorinated rubber, mixtures of EVA and chlorinated rubber, polyester, polyurethanes, polyvinyl acetate, polyvinyl chloride (PVC), and the like. Suitable matrix polymers are described in U.S. Pat. No. 5,447,784 which has been previously incorporated herein by reference. The SBR copolymer provides a transparent matrix for the static dissipative composition. The thickness of the heat sealable base layer **27** generally is dependent on the bond strength needed between the cover tape **20** and the carrier tape **10**. Generally, the necessary thickness is dependent on the desired tack, heat resistance, creep, chemical-moisture resistance, etc., of the cover tape **20**. Because the static dissipative composition is provided in a polymer matrix, it is easy to control the conductivity of the transparent, static dissipative, heat sealable layer **29**. In addition, the individual particles in the static dissipative composition are nonmigratory thereby providing a transparent, static dissipative, heat sealable layer **29** having uniform conductivity.

In addition to the heat sealable base layer **27**, the cover tape **20** may further include a second heat sealable base layer **28**. Typically, the second base layer **28** comprises the same polymer used in the first base layer **27** and is preferably a SBR copolymer. The second base layer **28** preferably further comprises an anti-blocking agent such as a polyolefin powder. A suitable polyolefin powder is Texture 5378W polyolefin powder sold by Shamrock Technologies. Preferably, the polyolefin powder has a particle size of less than about 75 microns to provide the desired antiblocking characteristics. Nevertheless, increased particle size results in increased clarity in the cover tape **20**. Therefore, the particle size is preferably about 25 microns. The anti-blocking agent may be interspersed in the second base layer **28** and/or may be provided on top of the second base layer as a separate layer. The second base layer **28** is preferably included in the cover tape **20** when the transparent, static dissipative, heat sealable layer **29** (described below) does not contain an anti-blocking agent. Nevertheless, even if an anti-blocking agent is included in the transparent, static dissipative, heat sealable layer **29**, the second base layer **28** may be included.

The cover tape **20** further comprises a transparent, static dissipative, heat sealable layer **29** adjacent the second surface of the polyester-based substrate **21** on the first heat sealable base layer **27** or the second heat sealable base layer **28**. The transparent, static dissipative heat sealable layer **29** comprises a static dissipative composition in a polymeric matrix. Exemplary compositions include intrinsically conductive polymers such as polyaniline, polyacetylene, polydiacetylene, polypyrrole, polythiophene, polyisonaphthene, polyheteroarylenevinylene in which the heteroarylene group can be, e.g., thiophene or pyrrole, poly-p-phenylene, polyphenylenesulphide, polyperinaphthalene, polyphthalocyanine, and their derivatives and copolymers; organometallic compounds such as organotitanates; particles selected from the group consisting of mica and titanium dioxide ($TiO_2$) which are conductively coated with coatings selected from the group consisting of doped oxides of antimony (Sb) and doped oxides of tin (as described in U.S. Pat. No. 5,447,784 to Williams et al.) ; and the like. Preferably, the static dissipative composition in the transparent, static dissipative heat sealable layer 29 is either polyaniline or an organotitanate and is provided in a polymeric matrix.

The polymeric matrix for the static dissipative composition in the transparent, static dissipative heat sealable layer **29** is preferably a styrene-butadiene rubber (SBR) copolymer such as Kraton 1650 sold by Shell Chemical Company as described above. Alternatively, the polymeric matrix may comprise chlorinated rubber, mixtures of EVA and chlorinated rubber, polyester, polyurethanes, polyvinyl acetate, polyvinyl chloride (PVC), and the like. Suitable matrix polymers are described in, for example, U.S. Pat. No. 5,447,784 which has been previously incorporated herein by reference. The SBR copolymer provides a transparent matrix for the static dissipative composition. Typically, when the transparent, static dissipative, heat sealable layer **29** comprises polyaniline in an SBR copolymer matrix, the amount of polyaniline is between about 5 and 10 percent by weight and the remainder of the transparent, static dissipative, heat sealable layer is the SBR copolymer. Nevertheless, the transparent, static dissipative, heat sealable layer **29** may further include an anti-blocking agent or various other additives. When the transparent, static dissipative, heat sealable layer **29** comprises polyaniline in a SBR copolymer matrix, the resulting cover tape **20** possesses high conductivity at its interface with the carrier tape **10** and the resistivity of the transparent, static dissipative, heat sealable layer is between about $10^7$ and $10^8$ ohms/square.

Alternatively, when the transparent, static dissipative, heat sealable layer **29** comprises an organotitanate and an anti-blocking agent, the amount of the organotitanate is between about 1 and 10 percent by weight, the amount of the anti-blocking agent is between about 1 and 10 percent by weight, and the remainder of the transparent, static dissipative, heat sealable layer comprises the SBR copolymer. Preferably, the amount of the organotitanate is 2 percent by weight and the amount of the anti-blocking agent is 4 percent by weight. When the transparent, static dissipative layer **29** comprises an organotitanate in a SBR copolymer matrix, the resulting cover tape **20** possesses good conductivity with resistivities between about $10^9$ and $10^{10}$ ohms/square, and also provides increased clarity to the cover tape.

The cover tape **20** is typically formed by laminating the polyester-based substrate **21** as described above, and then applying the remaining layers in succession to the polyester-based substrate to form the cover tape. Preferably, once the polyester-based substrate **21** is formed, the composition forming the tie layer **26** is applied to the substrate **21** (if not already formed onto the second lamina **23**), the first heat sealable base layer **27** is applied at about 8 pounds per ream (0.40 mil) to the tie layer, the second heat sealable base layer **28** is applied, if desired, to the first base layer at about 1 pound per ream, (0.05 mil) and the static, dissipative, heat sealable layer **29** is applied at about 0.5 pounds per ream (0.025 mil) to either the first or second base layer. The static dissipative composition which forms the transparent, static dissipative layer **25** is applied at about 0.2 pounds per ream (0.01 mil) to the first surface of the substrate **21** to form a transparent, heat sealable cover tape with top and bottom static, dissipative surfaces.

Preferably, the thickness of the cover tape **20** is between about 1.0 and 2.4 mil. As stated above, the preferred thickness of the polyester-based substrate **21** is not more than about 1.05 mils. The thickness and modulus of the polyester-based substrate **21** generally do not greatly affect the peelability of the cover tape **20** at peel angles of about 90°. Nevertheless, the thickness and modulus of the polyester-based substrate **21** may substantially affect the peelability of the cover tape **20** at peel angles approaching 180°. Removal of the cover tape **20** at peel angles approaching 180° is preferred because separation of the cover tape **20** from the carrier tape **10** occurs more readily and with less vibration of the packaged electronic components when compared to 90° peels. Generally speaking, thinner, low modulus cover tapes are easier to remove at peel angles approaching 180°. Specifically, relatively thin substrates constructed of low modulus materials require less heat sealable material than thick, high modulus substrates. This provides more consistent peel strengths which is particularly important when automated equipment is used to open the packages containing the electronic components. Therefore, thin, low modulus cover tapes are preferred in the present invention.

Furthermore, because less adhesive is used in the present invention, the peel strength does not increase greatly over long periods of time when the packages are stored. Preferably, the peel strength between the cover tape **20** and the carrier tape **10** is between about 30 and 70 grams at peel angles of approximately 180°.

In another aspect, the invention comprises a method of sealing an electronic component in a static-protective package. The method comprises inserting an electronic component into a recessed portion of a carrier tape, applying the transparent, static dissipative, heat sealable cover tape described above to the carrier tape to enclose the electronic component, and heating and pressurizing a portion of the cover tape for a predetermined dwell time to adhere the cover tape to the carrier tape and to seal the electronic component within the static-protective package. Generally, the width of the portion of the cover tape which is heated and pressurized to adhere to the carrier tape is dependent on the width of the outer perimeter of the carrier tape. Preferably, this portion has a width of between about 15 and 20 mils. This portion of the cover tape is preferably heated at a temperature between about 150°C and 210°C and pressurized at a pressure of between about 20 and 80 psi for a dwell time of between about 0.10 and 0.60 seconds to adhere the cover tape to the carrier tape. More preferably, this portion of the cover tape is preferably heated at a temperature between about 160°C and 180°C and pressurized at a pressure of between about 20 and 40 psi for a dwell time of between about 0.20 and 0.50 seconds to adhere the cover tape to the carrier tape.

The transparent, static dissipative cover tape of the invention has increased clarity over conventional cover tapes and is constructed of a lower modulus material which reduces the amount of adhesive necessary to heat seal the cover tape to the carrier tape. The resulting peel force necessary to separate the cover tape from the carrier tape is therefore more consistent from package to package and does not increase greatly over time which makes the static-protective package of the invention more storage stable than conventional cover tapes. In addition, the cover tapes may be removed from the carrier tape at peel angles approaching 180° which allows for minimization in the vibrations of the package when it is peeled open and smooth release of the cover tape from the carrier tape.

The present invention will be further illustrated by the following non-limiting examples.

Example 1

| Tape One | | |
|---|---|---|
| Two transparent, static dissipative cover tapes were prepared according to the invention having the following layer thicknesses. | | |
| Transparent, static dissipative layer (sulfonated polystyrene, wetting agent, isopropyl alcohol, water) Laminated polyester-based substrate | | 0.01 mil |
| total thickness | | 1.05 mil |
| first polyester laminae | 0.60 mil | |
| pressure sensitive adhesive (acrylic resin) | 0.20 mil | |
| second polyester laminae ("treated" PET) | 0.25 mil | |
| First SBR copolymer layer including Second SBR copolymer layer (including | | 0.40 mil |
| antiblocking agent) | | 0.05 mil |
| Transparent, static dissipative, heat sealable layer | | 0.025 mil |
| (SBR and polyaniline) | | |
| Total Thickness | | 1.535 mil |

| Tape Two | | |
|---|---|---|
| Transparent, static dissipative layer (sulfonated polystyrene, wetting agent, isopropyl alcohol, water) | | 0.01 mil |
| Laminated polyester-based substrate | | |
| total thickness | | 1.05 mil |
| first polyester laminae | 0.60 mil | |
| pressure sensitive adhesive (acrylic resin) | 0.20 mil | |
| second polyester laminae | 0.25 mil | |
| Copolyester tie layer (isophthalic copolymer) | | negl. |
| SBR copolymer layer | | 0.40 mil |
| Transparent, Static Dissipative Heat Sealable Layer | | 0.10 mil |
| (94% SBR, 2% organotitanate, and 4% anti-blocking agent by weight) | | |
| Total Thickness | | 1.56 mil |

The tapes when sealed to the carrier tape possessed the desired seal strengths and could be peeled away at angles approaching 180°. Both of the tapes possessed the desired clarity and static dissipative properties.

## Example 2

Tape One in Example 1 and a standard cover tape available from Neptco were tested using an accelerated aging test on sealed samples to determine the storage stability of the tapes. The equipment included an Advantek ATR-1000 tape and reel machine, a GPD Peel Force Tester, Model 856VS, and an Environtronics environmental chamber. The test parameters included a seal temperature of 170°C, a seal pressure of 30 psi, a seal dwell time of 0.35 seconds, a seal rail width of 0.015 inches, and a peel back speed of 300 mm per minute.

In the test procedure the samples were cut into 21 mm wide strips and sealed to an Advantek SO-2ØL-AC conductive carrier tape on the ATR-1000 machine. Samples were placed in the chamber and removed each day, being allowed to cool and thereafter tested. All of the samples were subjected to a 110 mm peel test with the first 10 mm ignored. The seal strength of Tape One increased by only 15% over an 8 day period compared to over 125% over the same period for the thicker, higher modulus tape from Neptco.

In the drawings and specification, there have been disclosed typical preferred embodiments of the invention and, although specific terms have been employed, they have been used in a generic and descriptive sense only and not for purposes of limitation, the scope of the invention being set forth in the following claims.

## Claims

1.    A transparent conductive heat sealable cover tape comprising:

a laminated polyester-based substrate having a first surface defining an outer surface of said substrate and a second surface, said laminated polyester-based substrate comprising respective first and second polyester laminae secured to one another by a pressure sensitive adhesive interposed between said first and second laminae; and
a transparent, static dissipative layer on said first surface of said substrate; and
a transparent, static dissipative, heat sealable layer on a second surface of said substrate opposite said first surface.

2.    The cover tape according to Claim 1 further comprising a tie layer on said second surface between said laminated polyester-based substrate and said heat sealable layer for enhancing the adhesion of said polyester-based substrate to said heat sealable layer.

3.    The cover tape according to Claim 2 wherein said tie layer comprises a copolyester.

4.    The cover tape according to any of the preceding claims wherein said transparent, static dissipative layer on said first surface comprises an anionic antistatic composition.

5. The cover tape according to any of the preceding claims wherein said transparent, static dissipative heat sealable layer comprises a sulfonated polystyrene.

6. The cover tape according to any of the preceding claims wherein said transparent, static dissipative, heat sealable layer comprises a static dissipative composition in a matrix of a styrene-butadiene copolymer.

7. The cover tape according to Claim 6 wherein said transparent, static dissipative, heat sealable layer further comprises polyaniline.

8. The cover tape according to Claim 6 wherein said transparent static dissipative, heat sealable layer comprises an organometallic compound.

9. The cover tape according to Claim 8 wherein said organometallic compound is an organotitanate.

10. The cover tape according to Claim 8 wherein said transparent static dissipative, heat sealable layer further comprises an anti-blocking agent.

11. The cover tape according to any of Claims 2-10 further comprising a first styrene-butadiene copolymer heat sealable base layer between said tie layer and said transparent, static dissipative, heat sealable layer.

12. The cover tape according to Claim 11 further comprising a second styrene-butadiene base layer between said first styrene-butadiene copolymer heat sealable base layer and said transparent, static dissipative, heat sealable layer and including an anti-blocking agent.

13. The cover tape according to any of the preceding claims wherein said transparent, static dissipative layer on said first surface has a resistivity of between about $10^6$ and $10^8$ ohms/square and said transparent, static dissipative, heat sealable layer on said second surface has a resistivity of between about $10^7$ and $10^{10}$ ohms/square.

14. A static-protective package for electronic components including the cover tape of any of the preceding claims.

15. A method of sealing an electronic component in a static-protective package using the cover tape of any of Claims 1-13.

Fig. 1.

EP 0 898 445 A2

Fig. 2.